# EUROPEAN PATENT SPECIFICATION

(11) **EP 0 384 692 B1**
(45) Date of publication and mention of the grant of the patent: **12.06.1996**
(21) Application number: 90301787.9
(22) Date of filing: 20.02.1990
(51) Int. Cl.: H01L 29/768, G11C 19/00

(54) **Charge-coupled device and process of fabrication thereof**
Ladungsverschiebeanordnung und Verfahren zu deren Herstellung
Dispositif à charges couplées et son procédé de fabrication

(30) Priority: 21.02.1989 JP 40995/89
(43) Date of publication of application: 29.08.1990
(73) Proprietor: SONY CORPORATION, Tokyo (JP)
(72) Inventor: Izumi, Akio, Shinagawa-ku Tokyo (JP); Maki, Yasuhito, Shinagawa-ku Tokyo (JP); Narabu, Tadakuni, Shinagawa-ku Tokyo (JP); Sato, Maki, Shinagawa-ku Tokyo (JP); Otsu, Koji, Shinagawa-ku Tokyo (JP); Saito, Katsuyuki, Shinagawa-ku Tokyo (JP)
(74) Representative: Senior, Alan Murray

(56) References cited:
- GB-A- 2 004 694
- US-A- 4 614 960
- PATENT ABSTRACTS OF JAPAN vol. 7, no. 88 (E-170)(1233) 12 April 1983 ; & JP-A-58 15 271

## Description

The present invention relates generally to a charge-coupled device (CCD) and a process for fabricating the same. More specifically, the invention relates to a CCD employing a floating gate amplifier, a distributed floating gate amplifier, or so forth, with a holding capability for controlling threshold voltage at peripheral elements and for preventing pin hole phenomenon.

As is well known, CCD's have been principally used for solid state image pick-up devices, semiconductor delay lines and so forth. A CCD is generally composed of a charge transfer section for transferring signalling charge, and a section forming its peripheral components. In most cases, the peripheral components in a CCD comprise MOS transistors. CCD's have various output gate structures, such as a floating diffusion amplifier, a floating gate amplifier, a distributed floating gate amplifier, and so forth.

In such CCD's, gate insulation layers are typically formed by silicon oxide layers. For instance, GB-A1-2004694 discloses a CCD structure in which an insulating layer formed by a silicon oxide layer beneath a silicon nitride layer is provided beneath the electrodes of the CCD section and also the gate electrode of an associated transistor. JP-A-5815271 discloses a similar structure for the charge transfer section of a CCD. US-A-4614960, on the other hand, discloses a structure for the charge transfer section of a CCD in which a dual nitride/oxide insulating layer is provided over most regions of the substrate but a thinned single oxide layer is provided beneath the direct injection gates.

However, silicon oxide layers tend to cause a pin hole phenomenon in the charge transfer section. In order to prevent the undesirable effects, there has been proposed a multi-layer structure having an insulating layer composed of a laminated silicon oxide layer, a silicon nitride layer, and a silicon oxide layer, referred to generally as an ONO structure. Such an ONO structure insulating layer is successful in prevention of the pin hole phenomenon. On the other hand, such an ONO structure insulating layer makes it difficult to obtain a desired threshold voltage at the peripheral components. Therefore, the ONO structure type insulating layer is not at all satisfactory for obtaining a desired performance of the CCD.

In order to solve the aforementioned drawbacks in the sole silicon oxide and ONO structure insulating layer, it is one possible approach to form the insulating layer by a combination of the sole silicon oxide insulating layer and the ONO structure insulating layer. In this possible combination, the ONO structure insulating layer is employed beneath the charge transfer section and the sole semiconductor insulating layer, such as a silicon oxide layer, is employed beneath the other electrodes, such as the gate electrodes of the peripheral components. With such construction, the aforementioned drawback may be resolved. However, on the other hand, such an insulating structure may cause difficulty in reading out a signal beneath the floating gate electrode and in smoothly transferring the signal through the transferring electrode. This is caused by discontinuity of the insulating layers.

Accordingly, this invention is directed to overcoming the drawbacks in the art relating to such CCDs.

Therefore, it is an overall object of the present invention to provide a charge-coupled device which can solve the problems in the prior art set forth above.

It is another object of the present invention to provide a charge-coupled device which can provide a capability for preventing the pin hole phenomenon and a capability for controlling the threshold voltage at elements in the peripheral components, without causing a degradation of its signal reading and transferring performance.

In order to accomplish the aforementioned and other objects, a charge-coupled device, according to the present invention, has a multi-layer structure wherein an insulating layer is formed beneath a transfer electrode, a floating electrode, and an electrode adjacent the floating electrodes. On the other hand, a sole-layer structure insulating layer is formed beneath a gate electrode of a peripheral component.

Thus, according to one aspect of the invention, there is provided a charge-coupled device comprising:
a semiconductor substrate;
a charge transfer section formed in the surface of the semiconductor substrate and having a plurality of electrodes including transfer electrodes and floating electrodes and a multi-layer structure insulating layer having a semiconductor oxide layer and a semiconductor nitride layer, which multi-layer structure insulating layer extends beneath all of said electrodes in said charge transfer section; and
a peripheral element section spaced and separated from said charge transfer section and in the semiconductor substrate, said peripheral element section including a MOS transistor having a gate electrode, said peripheral MOS transistor having a single layer structure insulating layer extending beneath said gate electrode.

The electrodes in the charge transfer section may include at least an output gate electrode and a pre-charge gate electrode. Preferably, the multi-layer structure insulating layer is composed of a first semiconductor oxide layer, a semiconductor nitride layer and a second semiconductor oxide layer. A plurality of such electrodes may be located on the charge transfer section.

According to another aspect of the invention, there is provided a process for fabricating a charge-coupled device comprising the steps of:
forming a multi-layer structure insulating layer including at least a semiconductor oxide layer and a semiconductor nitride layer in a mutually interfacing fashion over a semiconductor substrate; and
forming at least one first phase electrode on said multi-layer structure insulating layer and forming at least one second phase electrode of said charge transfer section on said multi-layer structure insulating layer;
locally removing said multi-layer structure insulating layer for a region where a peripheral element of the charge coupled device is to be formed;
forming a single-layer structure insulating layer for the region where said multi-layer structure insulating layer is removed;
forming an electrode of a peripheral element of said charge coupled device on said single-layer structure insulating layer; and
removing part of said single-layer structure insulating layer utilizing said electrode of said peripheral element as a mask said peripheral element being spaced and separated from said charge transfer section in the semiconductor substrate.

The process may further comprise the steps of forming an insulating layer covering each of the first phase electrodes on said multi-layer and forming a masking layer covering a region of said charge transfer section before the step of removing said multi-layer structure insulating layer. Also, the process may further comprise the steps of forming a surface insulating layer extending over said second phase electrodes and locally removing the surface insulating layer for forming a metallic electrode through a receptacle formed by removal of said surface insulating layer.

The present invention will be understood more fully from the detailed description given herebelow and from the accompanying drawings of the preferred embodiment of the invention which, however, should not be taken to limit the invention to the specific embodiment, but are for explanation and understanding only. In the drawings:-
Figure 1 is a section of the preferred embodiment of a charge-coupled device, according to the present invention; and
Figures 2(A) to 2(J) are illustrations showing various steps in the fabrication process of the preferred embodiment of the charge coupled device of Figure 1.

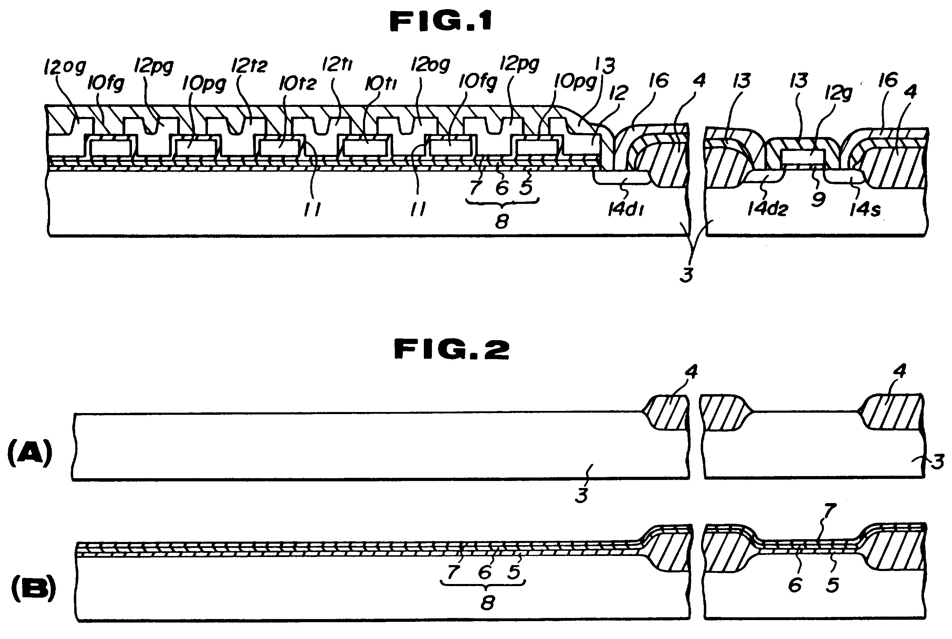

Referring now to the drawings, particularly to Figure 1, the preferred construction of a charge-coupled device (CCD), according to the present invention, is formed on a silicon substrate 3 as a semiconductor substrate. The CCD generally comprises a charge transfer section 1 and a peripheral element section 2. The preferred construction of the CCD has a floating gate amplifier type output structure, such as a floating gate amplifier or a distributed floating gate amplifier. In the shown construction, the CCD has a plurality of transfer electrodes 10t₁, 10t₂ . . . 10tₙ and 12t₁, 12t₂ . . . 12tₙ, pre-charge gates electrodes 10pg and 12pg, output gate electrodes 10og and 12og and floating gate electrodes 10fg and thus forms the floating gate amplifier type output structure. The CCD is associated with a MOS transistor as a peripheral component, which MOS transistor has as a gate electrode 12g, a source region 14s, and a drain region 14d₂.

The transfer electrodes 10t₁, 10t₂ ... 10tₙ and 12t₁, 12t₂ ... 12tₙ, the pre-charge gate electrodes 10pg and 12pg, the output gate electrodes 10og and 12og and the floating gate electrodes 10fg and 12fg are respectively formed on a multi-layer structure insulating layer 8. The insulating layer 8 is composed of a first insulating layer comprising a silicon dioxide (SiO2) layer 5 which is formed by heating oxidation performed for the corresponding area of the silicon substrate surface, a second insulating layer 6 comprising a silicon nitride (SiN) layer which is formed by vapor deposition on the first insulating layer, and a third insulating layer 7 comprising a silicon dioxide (SiO2) layer which is formed by vapor deposition on the second insulating layer.

The pre-charge gate electrodes 10pg and 12pg, the output gate electrodes 10og and 12og, and the floating gate electrodes 10fg and 12fg cooperate with the multi-layer structure insulating layer 8 for forming a charge transfer section 1 having a charge transfer line. As will be seen, respective adjacent electrodes 10pg, 12pg, 10fg, 12og, 10fg and 12fg are insulated from each other by an insulating layers 11. Also, the surface of the transfer section 1 is coated by an insulating layer 13. A drain region 14d₁ is formed in the silicon substrate 8 for draining the signal charge transferred through the transfer line in the charge transfer section 1. The drain region 14d₁ is separated from the drain region 14d₂ of the MOS transistor in the section 2 by a field insulating layer 4 which is coated by the insulating layer 13. An aluminum electrode 16 is formed above the insulating layer 13 covering the field insulating layer 4. With this aluminum electrode 16, the drain regions 14d₁ and 14d₂ are connected to each other.

As can be seen from Fig. 1, the gate electrode 12g of the MOS transistor is formed of a single layer structure insulating layer 9 which comprises a silicon dioxide (SiO2) layer.

With the shown construction, since the insulating layer 9 for the gate electrode 12g of the MOS transistor as the peripheral component is formed as a single layer structure silicon dioxide layer, its threshold voltage can be easily set at the designed level substantially in the conventionally known manner. On the other hand, since the multi-layer structure insulating layer 8 is employed for the charge transfer section 1, the pin hole phenomenon will not occur. In addition, since the transfer electrodes 10t₁, 10t₂ ... 10tₙ and 12t₁, 12t₂ ... 12tₙ, the pre-charge gate electrodes 10pg and 12pg, the output gate electrodes 10og and 12og and the floating gate electrodes 10fg and 12fg are formed on the common multi-layer structure insulating layer 8, a continuity between the electrodes can be provided for enabling a smooth transfer of the signal charge.

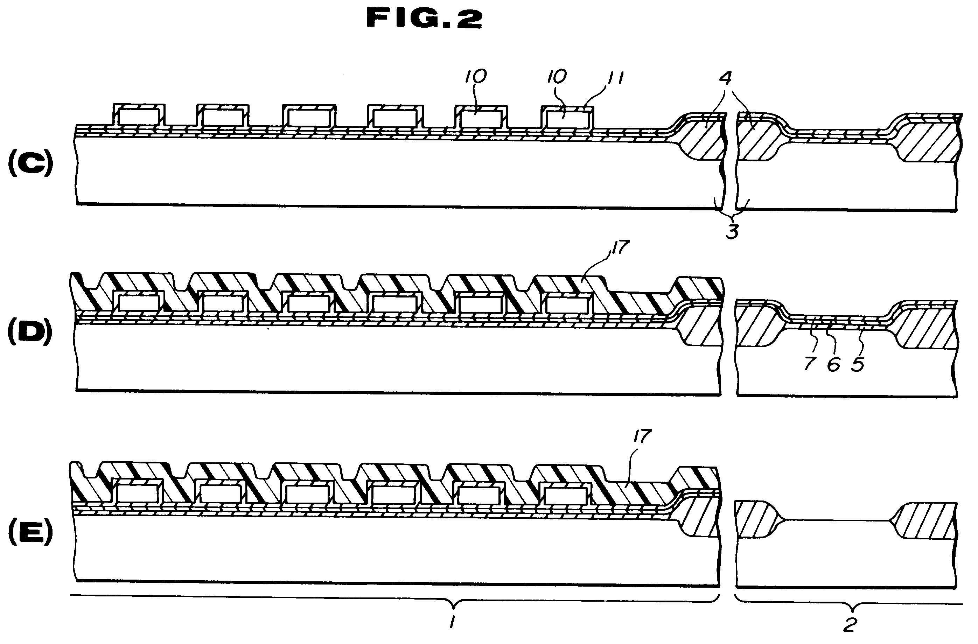

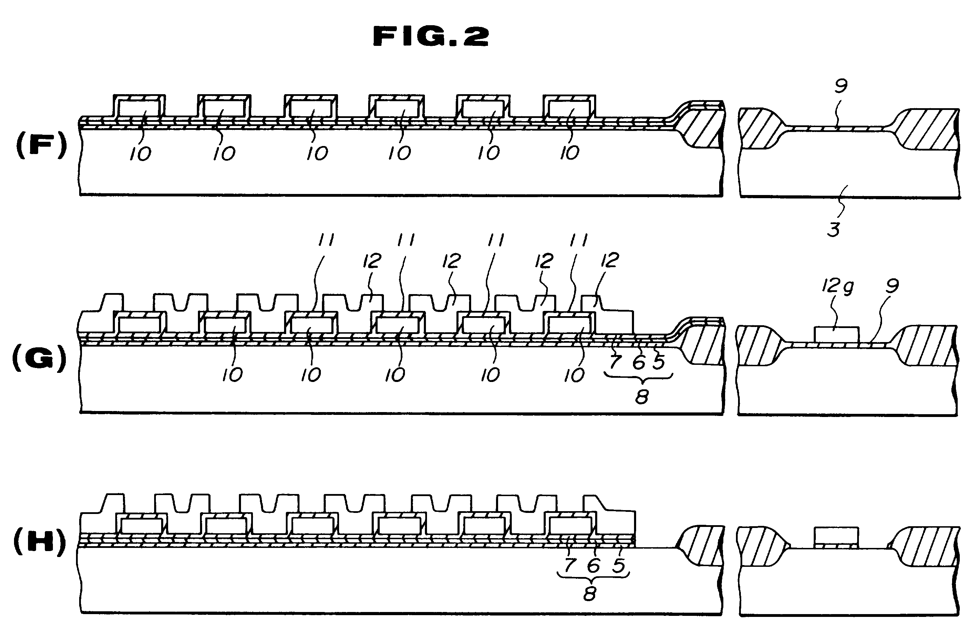

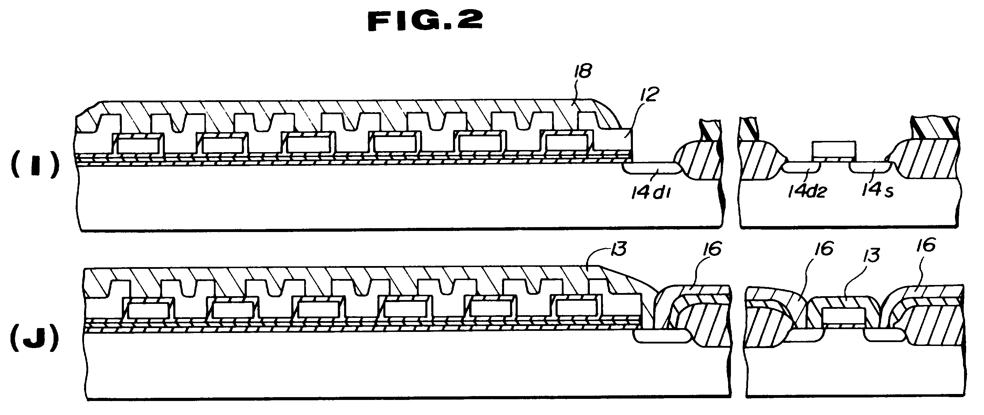

The process for fabricating the aforementioned preferred construction of the CCD will be discussed herebelow with reference to Figs. 2(A) to 2(J).

Fig. 2(A) shows the initial step of the preferred CCD fabrication process according to the present invention. As can be seen, at this step, the silicon substrate 3 is selectively or locally oxidized for forming the field insulating layer 4. Subsequently, as shown in Fig. 2(B), the multi-layer structure insulating layer 8 as previously described is formed on the overall surface of the silicon substrate 3. Practically, in this step of the process, the surface of the silicon substrate 3 is processed for oxidation by heating in order to form the silicon oxide layer 5 as the first insulating layer. As can be seen, the silicon oxide layer 5 thus formed adjoins the field insulating layer 4 formed in the substrate as shown in the step of Fig. 2a. After forming the first insulating layer 5 through the described heat treatment, chemical vapor deposition (CVD) is performed for the overall surface of the first insulating layer 5 for forming the adjacent silicon nitride layer 6 as the second insulating layer. Then, another chemical vapor deposition (CVD) is performed for the overall surface of the second insulating layer 6 for forming the adjacent silicon oxide layer 7 as the third insulating layer. Through the three stage processes, an ONO-type multi-layer structure insulating layer 8 is formed.

Thereafter, as shown in Fig. 2(C), the first phase electrodes 10, each with an adjacent insulating layer 11, are formed. The first phase electrodes 10 are formed by initially and locally performing chemical vapor deposition (CVD) of polycrystalline silicon on the insulating layer 8 and subsequently performing local etching for removing the extra part of the polycrystalline silicon. Then, an adjacent insulating layer 11 is formed by chemical vapor deposition of the silicon oxide. Therefore, after formation, the insulating layer 11 is integrated with the silicon oxide layer 7 as the third insulating layer.

Then, as shown in Fig. 2(D), a resisting layer 17 is formed over the charge transfer section 1. Utilizing the resisting layer 17 as a mask, the insulating layer 8 formed over the area where the MOS transistor or other peripheral components of the CCD are located, is removed by way of etching, as shown in Fig. 2(E). Subsequently, the surface is heat treated while maintaining the resisting layer 17. As a result, a heat-oxidized silicon oxide layer 9 is formed in the region 2 for the peripheral components, as shown in Fig. 2(F). Through this process, the single layer structure insulating layer 9 of the silicon oxide layer is formed for the region 2 forming the peripheral components, such as an MOS transistor. Then, the second phase polycrystalline electrodes 12 for the charge transfer section 1 and the electrode 12n for the peripheral component, e.g., an MOS transistor, are formed as shown in Fig. 2(G). During this process, the resisting layer 17 is removed. The second phase polycrystalline electrodes 12 are formed to have sections extending through the clearance formed between adjacent first phase electrodes 10 for direct contact with the insulating layer 8.

Utilizing the electrodes 12 and 12g as a mask, etching is performed for selectively removing the insulating layers 8 and 9, as shown in Fig. 2(H). Subsequently, an inorganic masking layer 18 is formed while maintaining the regions for which doping of a impurity is to be performed as shown in Fig. 2(I). In this process, for enabling an impurity doping process is self-alignment utilizing the electrodes as masks, the masking layer 18 is formed slightly smaller so as not to cover the peripheral portions of the electrodes. Particularly, for the region 2 to form the peripheral components, it is preferred to concentrate the masking layer 18 on the field insulating layer 4. After forming the masking layer 18, doping of an impurity is performed for forming a source region 14s and drain regions 14d₁ and 14d₂, as shown in Fig. 2(I). Subsequently, the insulating layer 13 is formed over the overall surface. Thereafter, the insulating layer 13 is locally etched for forming contact holes. Therefore, the insulating layer 13 covers the charge transfer section 1 and the MOS transistor in the region 2. Then, the aluminum electrodes 16 are formed as shown in Fig. 2(J).

While the present invention has been disclosed in terms of the preferred embodiment in order to facilitate better understanding of the invention, it should be appreciated that the invention can be embodied in various ways without departing from the principle of the invention as set out in the appended claims. For example, though the shown embodiment is directed to the type of CCD having floating gate amplifier, the invention is applicable for the type of CCD having the distributed floating gate amplifier.

## Claims

1. A charge-coupled device comprising:
a semiconductor substrate (3);
a charge transfer section (1) formed in the surface of the semiconductor substrate (3) and having a plurality of electrodes (10,12) including transfer electrodes (10t,12t) and floating electrodes (l0f) and a multi-layer structure insulating layer (8) having a semiconductor oxide layer (5,7) and a semiconductor nitride layer (6), which multi-layer structure insulating layer extends beneath all of said electrodes in said charge transfer section (1); and
a peripheral element section (2), said peripheral element section including a MOS transistor (2) having a gate electrode (12g), said peripheral MOS transistor (2) having a single layer structure insulating layer (9) extending beneath said gate electrode (12g), said peripheral element section being spaced and separated from said charge transfer section (1) in the semiconductor substrate (3).

2. A charge-coupled device according to claim 1, wherein said electrodes (10,12) further include at least an output gate electrode (10og,12og) and a pre-charge gate (10pg,12pg) electrode.

3. A charge-coupled device according to claim 1 or 2, wherein said multi-layer structure insulating layer (8) is composed of a first semiconductor oxide layer (5), a semiconductor nitride layer (6) applied on the first semiconductor oxide layer (5) and a second semiconductor oxide layer (7) applied on the semiconductor nitride layer (6).

4. A charge-coupled device according to claim 1, 2 or 3, wherein the thickness of the single layer structure insulating layer (9) is less than that of said multi-layer structure insulating layer (8).

5. A charge-coupled device according to claim 4, wherein the peripheral MOS transistor (2) is an analog transistor.

6. A process for fabricating a charge-coupled device according to any of the previous claims comprising the steps of:
forming a multi-layer structure (8) insulating layer including at least a semiconductor oxide layer (5,7) and a semiconductor nitride layer (6) in a mutually interfacing fashion over a semiconductor substrate (3); and
forming at least one first phase electrode (10) on said multi-layer structure insulating layer (8) and forming at least one second phase electrode (12) of a charge transfer section (1) on said multi-layer structure insulating layer (8);
locally removing said multi-layer structure insulating layer (8) for a region where a peripheral element (2) of the charge coupled device is to be formed;
forming a single-layer structure insulating layer (8) for the region where said multi-layer structure insulating layer is removed;
forming an electrode (12g) of said peripheral element (2) of said charge coupled device on said single-layer structure insulating layer (9); and
removing part of said single-layer structure insulating layer (9) utilizing said electrode (12g) of said peripheral element as a mask
said peripheral element being spaced and separated from said charge transfer section in the semiconductor substrate.

7. A process according to claim 6, which further comprises the steps of forming an insulating layer (11) covering each of a plurality of said first phase electrodes (10) on said multi-layer (8) and forming a masking layer (17) covering a region of said charge transfer section (1) before the step of removing said multi-layer structure insulating layer (8) using said masking layer.

8. A process according to claim 6 or 7, which further comprises the steps of forming a surface insulating layer (18) extending over a plurality of said second phase electrodes (12) and locally removing the surface insulating layer (18) for forming a metallic electrode (16) through a receptacle formed by removal of said surface insulating layer (18).

## Patentansprüche

1. Ladungsgekoppelte Einrichtung, die aufweist:
ein Halbleitersubstrat (3);
einen Ladungstransferabschnitt (1), der in der Oberfläche des Halbleitersubstrats (3) gebildet ist und mehrere Elektroden (10, 12) einschließlich Transfer-Elektroden (10t, 12t) und Fließelektroden (10f) und eine Isolationsschicht (8) mit einem Mehrfachschichtaufbau besitzt, die eine Halbleiter-Oxidschicht (5, 7) und eine Halbleiternitridschicht (6) besitzt, wobei sich die Mehrfachschicht-Isolationsschicht unterhalb aller Elektroden im Ladungstransferabschnitt (1) erstreckt; und
einen peripheren Elementenabschnitt (2), wobei der periphere Elementenabschnitt einen MOS-Transistor (2) besitzt, der eine Gate-Elektrode (12g) besitzt, wobei der periphere MOS-Transistor (2) eine Einzelschicht-Isolationsschicht besitzt, die sich unterhalb der Gate-Elektrode (12g) ausdehnt, wobei der periphere Elementenabschnitt vom Ladungstransferabschnitt (1) im Halbleitersubstrat (3) beabstandet und getrennt ist.

2. Ladungsgekoppelte Einrichtung nach Anspruch 1, wobei die Elektroden (10, 12) außerdem zumindest eine Ausgangs-Gate-Elektrode (10og, 12og) und eine Vorlade-Gate-Elektrode (10pg, 12pg) aufweisen.

3. Ladungsgekoppelte Einrichtung nach Anspruch 1 oder 2, wobei die Mehrfachschicht-Isolationsschicht (8) aus einer ersten Halbleiteroxidschicht (5), einer Halbleiternitridschicht (6), die auf der ersten Halbleiteroxidschicht (5) aufgebracht ist, und aus einer zweiten Halbleiteroxidschicht (7), die auf der Halbleiternitridschicht (6) aufgebracht ist, besteht.

4. Ladungsgekoppelte Einrichtung nach Anspruch 1, 2 oder 3, wobei die Dicke der Einzelschicht-Isolationsschicht (9) geringer ist als die der Mehrfachschicht-Isolationsschicht (8).

5. Ladungsgekoppelte Einrichtung nach Anspruch 4, wobei der periphere MOS-Transistor (2) ein analoger Transistor ist.

6. Verfahren zur Herstellung einer ladungsgekoppelten Einrichtung nach einem der vorhergehenden Ansprüche, das folgende Schritte aufweist:
Bildung einer Mehrfachschicht-Isolationsschicht (8) auf einem Halbleitersubstrat (3), die zumindest eine Halbleiteroxidschicht (5, 7) und eine Halbleiternitridschicht (6), die dazwischen liegt, aufweist; und
Bildung zumindest einer Erst-Phasen-Elektrode (10) auf der Mehrfachschicht-Isolationsschicht (8) und Bildung zumindest einer Zweit-Phasen-Elektrode (12) eines Ladungstransferabschnitts (1) auf der Mehrfachschicht-Isolationsschicht (8);
lokales Entfernen der Mehrfachschicht-Isolationsschicht (8) in einem Bereich, wo ein peripheres Element (2) der ladungsgekoppelten Einrichtung gebildet werden soll;
Bildung einer Einzelschicht-Isolationsschicht (8) in dem Bereich, wo die Mehrfachschicht-Isolationsschicht entfernt ist;
Bildung einer Elektrode (12g) des peripheren Elements (2) der ladungsgekoppelten Einrichtung auf der Einzelschicht-Isolationsschicht (9); und
Entfernen eines Teils der Einzelschicht-Isolationsschicht (9), wobei die Elektrode (12g) des peripheren Elements als Maske verwendet wird
wobei das periphere Element vom Ladungstransferabschnitt im Halbleitersubstrat beabstandet und getrennt ist.

7. Verfahren nach Anspruch 6, welches weiter die Schritte zum Bilden einer Isolationsschicht (11), die die mehreren Erst-Phasen-Elektroden (10) auf der Mehrfachschicht (8) überdeckt, und die Bildung einer Maskenschicht (17) aufweist, die einen Bereich des Ladungstransferabschnitts (1) überdeckt, vor dem Schritt zur Entfernung der Mehrfachschicht-Isolationsschicht (8), wobei die Maskenschicht verwendet wird.

8. Verfahren nach Anspruch 6 oder 7, welches weiter die Schritte zur Bildung einer Oberflächenisolationsschicht (18) aufweist, die sich über die mehreren Zweit-Phasen-Elektroden (12) erstreckt, und lokales Entfernen der Oberflächenisolationsschicht (18), um eine metallische Elektrode (16) in einer Aufnahme zu bilden, die durch Entfernen der Oberflächenisolationsschicht (18) gebildet ist.

## Revendications

1. Dispositif à couplage par charges, comprenant :
un substrat semi-conducteur (3),
une section (1) de transfert de charge formée à la surface du substrat semi-conducteur (3) et ayant plusieurs électrodes (10, 12) comprenant des électrodes de transfert (10t, 12t) et des électrodes flottantes (10f) et une couche isolante (8) à structure multicouche ayant une couche (5, 7) d'oxyde semi-conducteur et une couche (6) de nitrure semi-conducteur, la couche isolante à structure multicouche étant placée sous toutes les électrodes de la section de transfert de charge, et
une section (2) de composant périphérique, la section de composant périphérique comprenant un transistor MOS (2) ayant une électrode de grille (12g), le transistor MOS périphérique (2) ayant une couche isolante (9) à structure à une seule couche placée sous l'électrode de grille (12g), la section de composant périphérique étant placée à distance de la section (1) de transfert de charge et étant séparée de celle-ci dans le substrat semi-conducteur (3).

2. Dispositif à couplage par charges selon la revendication 1, dans lequel les électrodes (10, 12) comportent en outre au moins une électrode de grille de sortie (10og, 12og) et une électrode de grille de charge préalable (10pg, 12pg).

3. Dispositif à couplage par charges selon la revendication 1 ou 2, dans lequel la couche isolante (8) à structure multicouche est composée d'une première couche (5) d'oxyde semi-conducteur, d'une couche (6) de nitrure semi-conducteur appliquée sur la première couche (5) d'oxyde semi-conducteur, et d'une seconde couche (7) d'oxyde semi-conducteur appliquée sur la couche (6) de nitrure semi-conducteur.

4. Dispositif à couplage par charges selon la revendication 1, 2 ou 3, dans lequel l'épaisseur de la couche isolante (9) à structure à une seule couche est inférieure à celle de la couche isolante (8) à structure multicouche.

5. Dispositif à couplage par charges selon la revendication 4, dans lequel le transistor MOS périphérique (2) est un transistor analogique.

6. Procédé de fabrication d'un dispositif à couplage par charges selon l'une quelconque des revendications précédentes, comprenant les étapes suivantes :
la formation d'une couche isolante à structure multicouche (8) comprenant au moins une couche d'oxyde semi-conducteur (5, 7) et une couche de nitrure semi-conducteur (6) formant des interfaces mutuels sur un substrat semi-conducteur (3), et
la formation d'au moins une première électrode de phase (10) sur la couche isolante à structure multicouche (8) et la formation d'au moins une seconde électrode de phase (12) de la section de transfert de charge (1) sur la couche isolante à structure multicouche (8),
l'extraction locale de la couche isolante à structure multicouche (8) d'une région dans laquelle un composant périphérique (2) du dispositif à couplage par charges doit être formé,
la formation d'une couche isolante à structure à une seule couche (8) dans la région dans laquelle la couche isolante à structure multicouche est retirée,
la formation d'une électrode (12g) d'un composant périphérique (2) du dispositif à couplage par charges sur la couche isolante à structure à une seule couche (9), et
l'extraction d'une partie de la couche isolante à structure à une seule couche (9) utilisant l'électrode (12g) du composant périphérique comme masque,
le composant périphérique étant placé à distance de la section de transfert de charge dans le substrat semi-conducteur et étant séparé de cette section.

7. Procédé selon la revendication 6, qui comporte en outre des étapes de formation d'une couche isolante (11) recouvrant chacune de plusieurs premières électrodes (10) de phase sur la couche (8) à structure multicouche et formant une couche de masque (17) recouvrant une région de la section de transfert de charge (1) avant l'étape d'extraction de la couche isolante (8) à structure multicouche à l'aide de la couche de masque.

8. Procédé selon la revendication 6 ou 7, qui comporte en outre des étapes de formation d'une couche isolante de surface (18) disposée sur plusieurs secondes électrodes (12) de phase, et d'extraction locale de la couche isolante de surface (18) pour la formation d'une électrode métallique (16) dans un réceptacle formé par enlèvement de la couche isolante de surface (18).
